Europäisches Patentamt

(19) **European Patent Office**

Office européen des brevets

(11) Numéro de publication : **0 024 222**
**B1**

(12) **FASCICULE DE BREVET EUROPÉEN**

(45) Date de publication du fascicule du brevet :
16.11.83

(51) Int. Cl.³ : **H 01 L 21/28**, H 01 L 21/00,
H 01 L 29/80, H 01 L 27/18

(21) Numéro de dépôt : **80401084.1**

(22) Date de dépôt : **22.07.80**

(54) **Procédé de fabrication d'un transistor à effet de champ à grille SCHOTTKY autoalignée.**

(30) Priorité : **27.07.79 FR 7919424**

(43) Date de publication de la demande :
**25.02.81 Bulletin 81/08**

(45) Mention de la délivrance du brevet :
**16.11.83 Bulletin 83/46**

(84) Etats contractants désignés :
**DE FR GB**

(56) Documents cités :
**EP A 0 005 351**
**EP A 0 011 477**
**EP A 0 013 342**
**FR A 2 094 036**
**JP A 52 128 077**
**US A 4 029 522**

**IEEE JOURNAL OF SOLID-STATE CIRCUITS, Vol. SC-12, no. 5, octobre 1977 New York US T.J. RODGERS et al. : « V-MOS-Memory Techno-logy », pages 515-524.**

**IBM TECHNICAL DISCLOSURE BULLETIN Vol. 22, no. 8B, janvier 1980 New York US V.L. RIDEOUT : « Fabrication method for high performance mesfet », pages 3861-3863**

**« Patent Abstracts of Japan », vol. 2, no 11, 26-01-1978**

(73) Titulaire : **THOMSON-CSF**
**173, Boulevard Haussmann**
**F-75379 Paris Cedex 08 (FR)**

(72) Inventeur : **Tonnel, Eugène**
**"THOMSON - CSF"- SCPI 173, Bld Haussmann**
**F-75360 Paris Cedex 08 (FR)**

(74) Mandataire : **de Beaumont, Michel et al**
**THOMSON-CSF SCPI 173, Bld Haussmann**
**F-75379 Paris Cedex 08 (FR)**

## Procédé de fabrication d'un transistor à effet de champ à grille Schottky autoalignée

La présente invention concerne un procédé de fabrication d'un transistor à effet de champ à grille Schottky autoalignée.

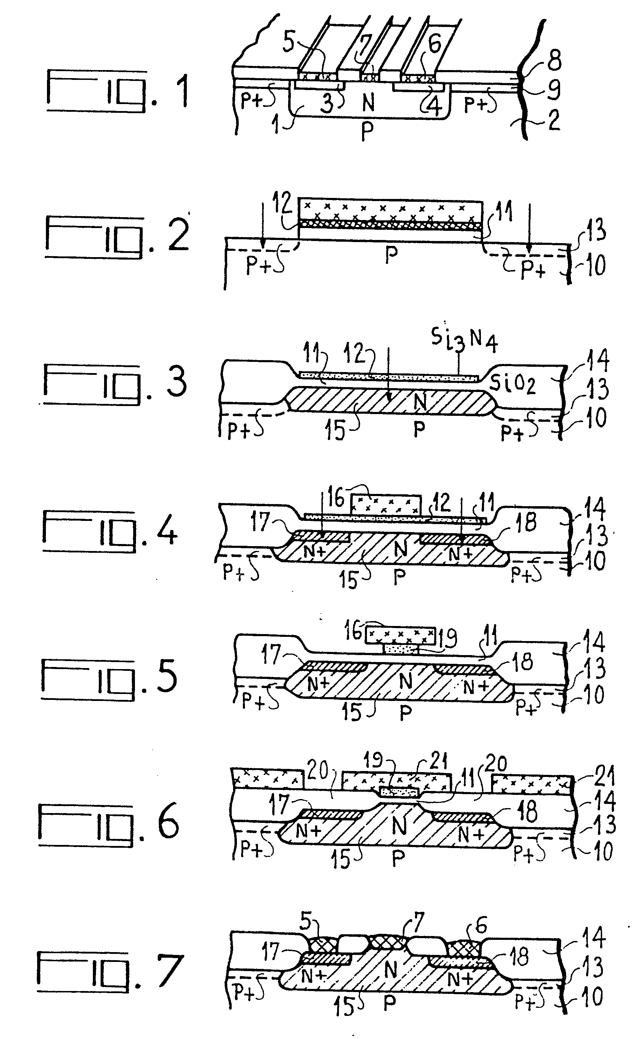

Un transistor à effet de champ à canal N en silicium à grille Schottky autoalignée est couramment appelé dans la technique MESFET. Un tel transistor est schématiquement représenté en figure 1. Il comprend, dans un caisson 1 de type N ménagé dans un substrat 2 de type P des zones 3 et 4 de type $N^+$ destinées à servir respectivement de source et de drain. Des métallisations 5 et 6 établissent un contact ohmique avec ces zones 3 et 4 fortement dopées. Une métallisation 7 est déposée sur la partie superficielle du caisson intermédiaire entre les zones de source et de drain. Cette métallisation, déposée sur la couche 1 de type N forme avec cette couche une barrière de Schottky. L'ensemble de la structure, en dehors des zones métallisées, est recouvert par une couche d'un diélectrique 8, couramment de la silice. La couche P est recouverte à sa surface supérieure, en dehors des zones où est formé le caisson 1, d'une zone 9 surdopée de type $P^+$.

Un transistor à effet de champ tel que représenté en figure 1 présente notamment des applications dans le domaine des très hautes fréquences, pouvant aller jusqu'à quelques gigahertz. Dans ce domaine, de fréquences, il est particulièrement important de diminuer les capacités et les résistances parasites éventuelles. D'autre part, pour un bon fonctionnement du composant, il est souhaitable qu'il se présente une symétrie aussi bonne que possible entre les zones de source et de drain. Pour ce faire, il importe notamment que le contact Schottky 7 sur la zone de canal soit exactement centré et le plus proche possible par rapport aux limites en regard des régions de source et de drain.

Les divers procédés connus pour réaliser une telle structure emploient des successions d'étapes de masquage et il faut alors repositionner chaque masque successif pour qu'il revienne en position précise par rapport au masque précédent. Il en résulte nécessairement une erreur de positionnement de l'ordre du micron, c'est-à-dire, avec les dimensions des dispositifs envisagés, une erreur relative très importante. Le brevet américain 4 029 522 décrit un procédé d'autoalignement particulier dans le cas où les couches de drain et de source sont enterrées au niveau où elles sont proches du canal. En ce cas, le masque délimitant les frontières en regard de ces couches enterrées est identique au masque déterminant l'ouverture du contact Schottky, ce qui n'est pas le cas quand, comme on l'envisage dans la présente invention, les couches de drain et de source sont superficielles. Il faut alors normalement réaliser un masquage supplémentaire pour prévoir une ouverture de contact plus petite que le masque ayant servi à délimiter les zones en regard des couches de source et de drain.

La présente invention vise un procédé pour obtenir de façon automatique un centrage de la métallisation de canal par rapport aux limites en regard des zones de source et de drain.

Ainsi, la présente invention a trait à un procédé de fabrication d'un transistor à effet de champ à grille Schottky autoalignée, comprenant une région de source et une région de drain séparées par une région de canal de même type de conductivité mais à plus faible niveau de dopage, comprenant les étapes suivantes : former sur une partie de la surface d'une tranche de silicium, dopée selon un premier type de conductivité, un empilage d'une couche de silice d'une première épaisseur et d'une couche de nitrure de silicium, cet empilage recouvrant sensiblement une région où l'on veut former les ensembles drain-canal-source ; procéder à une implantation d'un dopant du premier type de conductivité, cette implantation étant masquée par ledit empilage ; former une couche de silice en dehors des zones couvertes par ledit empilage, cette couche ayant une deuxième épaisseur supérieure à la première ; procéder à une implantation d'un dopant du deuxième type de conductivité, cette implantation étant masquée par la couche de silice avant la deuxième épaisseur ; former sur la couche de nitrure une couche de résine recouvrant sensiblement la zone dans laquelle on souhaite former le canal ; procéder à une implantation d'un dopant du deuxième type de conductivité, cette implantation étant masquée par la couche de résine et par la couche de silice ayant la deuxième épaisseur ; attaquer la couche de nitrure pour l'enlever en dehors des emplacements recouverts par la résine et partiellement sous cette couche de résine ; enlever la couche de résine ; former à nouveau une couche de silice en dehors des emplacements recouverts de nitrure selon une épaisseur supérieure à ladite première épaisseur ; déposer une couche de résine, l'ouvrir aux emplacements où l'on souhaite ménager les contacts de drain et de source, et attaquer la couche de silice sousjacente aux ouvertures et éliminer la résine, enlever par attaque sélective le nitrure restant, puis attaquer la silice sur une épaisseur correspondant à la première épaisseur, d'où il résulte que la tranche de silicium se trouve à nu aux emplacements où l'on souhaite effectuer les contacts de drain, de source et de canal.

Ces objets, caractéristiques et avantages ainsi que d'autres de la présente invention seront explicités de façon détaillée dans la description suivante d'un mode de réalisation particulier faite en relation avec les figures jointes parmi lesquelles :

la figure 1 représente une structure de transistor à effet de champ à canal N à grille Schottky, connue en elle-même ; et

les figures 2 à 7 illustrent diverses étapes du procédé de fabrication d'un transistor à effet de champ à canal N à grille Schottky autoalignée selon la présente invention.

Dans ces diverses figures de mêmes références

désignent de mêmes éléments, zones ou couches. Conformément à l'usage dans le domaine de la représentation des structures de semiconducteurs, les diverses dimensions des figures schématiques jointes ne sont pas tracées à l'échelle mais au contraire certaines de leurs dimensions sont dilatées pour en faciliter la compréhension. La description suivante traite d'un procédé utilisant un substrat de silicium de type P. Bien entendu, on pourrait partir initialement d'un substrat de silicium de type N à condition d'inverser de façon correspondante tous les types de conductivité décrits et représentés.

Comme le montre la figure 2, le procédé selon la présente invention utilise initialement un substrat 10 de type P. On notera que ce substrat de type P pourra être, dans certains cas pratiques, une couche de type P obtenue par diffusion ou épitaxie à partir d'une plaquette de silicium de même type ou de type opposé. Sur ce substrat 10 de type P est formée une couche 11 de silice ou oxyde de silicium, couramment appelée simplement dans la pratique couche d'oxyde, revêtue d'une couche 12 de nitrure de silicium, couramment appelée dans la pratique et par abréviation couche de nitrure. L'empilement des couches 11 et 12 est gravé pour maintenir un empilement localisé tel que représenté sur la figure. La plaquette est alors placée en regard d'une source d'implantation. L'empilement des couches 11 et 12 et de la résine photosensible sert de masque et seules les zones du substrat externes à cet empilement subissent l'implantation. On obtient ainsi une couche implantée 13 de type P⁺.

Comme le montre la figure 3, on forme ensuite une couche épaisse de silice 14 sur les zones de la plaquette non recouvertes de nitrure, après enlèvement de la couche de résine. Cette localisation se fait automatiquement en plaçant la plaquette dans un four en atmosphère oxydante, la croissance de silice ne se faisant pas dans les zones protégées par le nitrure. Après cela, on procède à une étape d'implantation d'un dopant de type N. L'implantation est masquée par la couche de silice épaisse 14 et se produit essentiellement en dessous de la couche de nitrure 12. On obtient ainsi une couche 15 de type N. L'épaisseur de la couche de silice 14 doit être suffisamment grande pour obtenir l'effet de masquage d'implantation decrit ci-dessus. Il est clair en conséquence que la couche de silice 14 est nettement plus épaisse que la couche de silice 11 formée lors de la première étape, cette couche de silice 11 n'ayant pas d'ailleurs un rôle fondamental mais servant à permettre, quand cela sera souhaitable, une attaque de la couche de nitrure sans endommager le silicium sousjacent.

Lors de l'étape illustrée en figure 4, une couche de résine 16 est déposée au-dessus d'une partie de la couche de nitrure 12, la largeur de la couche de résine 16 correspondant sensiblement à la largeur de la zone de canal comme on le verra ci-après. Cette couche de résine 16 sert, avec la couche d'oxyde épaisse 14, de masque d'implantation et l'on effectue une implantation de type N à fort niveau de dopage uniquement en dessous des zones où le nitrure est apparent. On obtient ainsi des régions de drain et de source 17 et 18. Lors de l'étape suivante, illustrée en figure 5, on procède à une attaque de la couche de nitrure 12. Cette attaque est poursuivie jusqu'à ce que le nitrure soit partiellement attaqué en dessous de la couche de résine 16. Il est clair que cette attaque sous la couche de résine est symétrique et qu'ainsi le plot de nitrure 19 restant est automatiquement centré sur les limites en regard des couches de type N 17 et 18.

Après ces étapes, et comme l'illustre la figure 6, on enlève la couche de résine 16, et l'on procède à une oxydation thermique de la tranche pour obtenir partout une épaisseur d'oxyde plus importante que celle se trouvant sous le plot de nitrure 19. On obtient notamment une surépaisseur d'oxyde au-dessus des zones N⁺ 17 et 18. Cette partie en surépaisseur de la couche d'oxyde est désignée par la référence 20. Après cela, pour établir un contact avec les régions 17 et 18, on dépose sur le substrat un masque de résine désigné par la référence 21, on ouvre ce masque et la portion de la couche de silice 20 sousjacente pour mettre à nu une partie des couches 17 et 18. Dans cette étape, il importe peu de laisser une très faible épaisseur de silice du moment qu'elle est du même ordre de grandeur que l'épaisseur de silice 11 se trouvant sous le plot de nitrure 19. Il faut souligner que le positionnement de ce masque n'est pas critique.: le fonctionnement du dispositif dépend peu du centrage des contacts sur les zones N⁺.

Ensuite, comme le représente la figure 7, on enlève le masque de résine 21, on attaque, par exemple à l'aide d'un plasma le plot de nitrure 19, puis on plonge la plaquette dans un milieu attaquant la silice. La durée de trempage dans le bain d'attaque est suffisamment courte pour que seulement une faible épaisseur de silice soit enlevée. On enlève ainsi la faible épaisseur de silice qui se trouvait sous le plot de nitrure 19 ainsi que, éventuellement, la faible épaisseur de silice restant au-dessus des zones où l'on souhaite établir le contact avec les couches 17 et 18. Ainsi, par ce procédé, l'ouverture du contact Schottky avec le canal se trouve exactement centrée entre les limites en regard des zones de source et de drain 17 et 18.

Enfin, on procède de façon classique à un dépôt de platine ou d'un autre métal, à un alliage avec le silicium, à un enlèvement du platine, puis à un dépôt d'une métallisation de reprise de contact.

On notera que, par suite des étapes successives d'oxydation thermique décrites précédemment, la plaquette prend, au niveau de chaque transistor formé une structure étagée à trois niveaux, le substrat initial se trouvant à un premier niveau sous la couche d'oxyde épaisse 14, les diffusions de drain et de source 17 et 18 se trouvant à un niveau un peu plus élevé sous les métallisations et la couche d'oxyde 20, et enfin la zone centrale du canal avec laquelle est établie le contact de Schottky se trouvant à un niveau supérieur.

La première implantation illustrée en figure 2 pour former la couche 13 de type P$^+$ peut être une implantation de bore, la deuxième implantation de type N pour former le caisson 15 peut être une implantation de phosphore, la troisième implantation pour former des régions surdopées de source et de drain 17 et 18 peut être une implantation d'arsenic.

La présente invention n'est pas limitée au mode de réalisation qui a été explicitement décrit mais en comprend les diverses variantes et généralisation contenues dans les définitions données par les revendications ci-après.

A titre d'exemple numérique, on peut indiquer que la structure suivante a été réalisée par la demanderesse :

— substrat initial P2 : résistivité 10 à 20 $\Omega$/cm-dopage 10$^{15}$ at/cm$^3$

— couche 11 SiO$_2$ : épaisseur 40 nm

— couche 12 Si$_3$N$_4$ : épaisseur 100 nm

— couche 13   —    bore    implanté    70 keV ; 8 · 10$^{12}$ at/cm$^2$

— canal 15 — phosphore implanté 150 keV ; 10$^{13}$ at/cm$^2$

— source-drain 17-18   —    arsenic    implanté 100 keV ; 10$^{15}$ at/cm$^2$

**Revendications**

1. Procédé de fabrication d'un transistor à effet de champ à grille Schottky autoalignée, comprenant une région de source et une région de drain séparées par une région de canal de même type de conductivité mais à plus faible niveau de dopage, caractérisé en ce qu'il comprend les étapes suivantes :

a) former sur une partie de la surface d'une tranche de silicium, dopée selon un premier type de conductivité, un empilage d'une couche de silice d'une première épaisseur et d'une couche de nitrure de silicium, cet empilage recouvrant sensiblement une région où l'on veut former les ensembles drain-canal-source ;

b) procéder à une implantation superficielle d'un dopant du premier type de conductivité, cette implantation étant masquée par ledit empilage ;

c) former une couche de silice en dehors des zones couvertes par ledit empilage, cette couche ayant une deuxième épaisseur supérieure à la première ;

d) procéder à une implantation superficielle d'un dopant du deuxième type de conductivité, cette implantation étant masquée par la couche de silice ayant la deuxième épaisseur ;

e) former sur la couche de nitrure une couche de résine recouvrant sensiblement la zone dans laquelle on souhaite former le canal ;

f) procéder à une implantation superficielle d'un dopant du deuxième type de conductivité, cette implantation étant masquée par la couche de résine et par la couche de silice ayant la deuxième épaisseur ;

g) attaquer la couche de nitrure pour l'enlever en dehors des emplacements recouverts par la résine et partiellement sous cette couche de résine ;

h) enlever la couche de résine ;

i) former à nouveau une couche de silice en dehors des emplacements recouverts de nitrure selon une épaisseur supérieure à ladite première épaisseur ;

j) déposer une couche de résine, l'ouvrir aux emplacements où l'on souhaite ménager les contacts de drain et de source et attaquer la couche de silice sousjacente aux ouvertures ;

k) éliminer la résine, enlever par attaque sélective le nitrure restant, puis attaquer la silice sur une épaisseur correspondant à la première épaisseur, d'où il résulte que la tranche de silicium se trouve à nu aux emplacements où l'on souhaite effectuer les contacts de source, de drain et de canal ;

l) former de façon classique des métallisations.

2. Procédé de fabrication selon la revendication 1, caractérisé en ce que les diverses étapes de formation d'une couche de silice sont des étapes d'oxydation thermique.

3. Procédé selon la revendication 2, caractérisé en ce que l'implantation réalisée lors de l'étape b) est une implantation de bore.

4. Procédé selon la revendication 3, caractérisé en ce que l'implantation réalisée lors de l'étape d) est une implantation de phosphore.

5. Procédé selon la revendication 4, caractérisé en ce que l'implantation réalisée au cours de l'étape f) est une implantation d'arsenic.

6. Procédé selon l'une quelconque des revendications 1 à 5, caractérisé en ce qu'il comprend en outre les étapes consistant à former un alliage platine/silicium au niveau des diverses ouvertures dans la couche de silice.

7. Procédé de fabrication d'un transistor à effet de champ à grille Schottky autoalignée à partir d'un substrat d'un premier type de conductivité, caractérisé en ce qu'il comprend les étapes suivantes :

a) placer le substrat dans un réacteur pour former une couche de silice thermique d'une première épaisseur puis une couche de nitrure, ces couches étant délimitées d'une façon prédéterminée selon un premier masque ;

b) placer la plaquette dans un dispositif d'implantation et implanter un dopant d'un premier type de conductivité, cette implantation étant masquée par lesdites couches ;

c) placer le substrat dans un réacteur pour former une seconde couche de silice thermique d'une seconde épaisseur supérieure à la première ;

d) soumettre à nouveau la tranche à une implantation d'un dopant du deuxième type de conductivité, cette implantation étant masquée par la seconde couche de silice ;

e) déposer une couche de résine aux emplacements où l'on souhaite former le canal ;

f) resoumettre la tranche à une implantation par un dopant du deuxième type de conductivité, cette implantation étant masquée par la seconde couche de silice et par la couche de résine ;

g) placer la tranche dans une enceinte d'attaque sélective du nitrure de façon à produire aussi une attaque latérale du nitrure sous la résine ;

h) placer la tranche dans un bain d'attaque de la résine ;

i) placer la tranche dans un four en atmosphère oxydante pour former une couche de silice thermique ;

j) déposer une nouvelle couche de résine, masquer, ouvrir aux emplacements où l'on souhaite ménager les contacts de drain et de source, puis placer la tranche dans un bain d'attaque sélective de la silice ;

k) placer la tranche dans un bain d'attaque de la résine, puis dans une enceinte d'attaque sélective du nitrure, puis dans un bain d'attaque sélective de la silice pendant une durée propre à attaquer une épaisseur correspondant sensiblement à la première épaisseur ;

l) former de façon classique des métallisations.

**Claims**

1. Method of producing a field effect transistor having a self-aligned Schottky gate, comprising source and drain regions separated by a channel region of the same conductivity type but having a lower doping level, characterized in that it comprises the following steps :

a) forming a stack of a silica layer having a first thickness and of a silicon nitride layer on part of the surface of a silicon silice, said stack substantially covering a region where the drain, channel and source units are to be formed ;

b) performing a superficial implantation with a dopant of the first conductivity type, said implantation being masked by said stack ;

c) forming a silica layer outside the zones covered by said stack, said layer having a second thickness exceeding the first thickness ;

d) performing a superficial implantation with a dopant of the second conductivity type, said implantation being masked by the silica layer having the second thickness ;

e) forming a resin layer on the nitride layer, said resin layer covering substantially the zone where the channel is to be formed ;

f) performing a superficial implantation with a dopant of the second conductivity type, said implantation being masked by the resin layer and by the silica layer having the second thickness ;

g) the nitride layer is attacked to be removed outside the zones covered by the resin and partially beneath said resin layer ;

h) removing the resin layer ;

i) forming another silica layer outside the zones covered by the nitride with a thickness exceeding said first thickness ;

j) deposition of a resin layer, opening the resin layer at the locations where the drain and source contacts are to be arranged and attacking the silica layer beneath the opening ;

k) the resin is removed, the remaining nitride is removed by selective attack, the silica is attacked to a thickness corresponding to the first thickness resulting into the silicon slice being bared at the locations where the source, drain and channel contacts are to be formed ;

l) metallizations are formed in conventional manner.

2. Production method in accordance with claim 1, characterized in that the various steps of forming a silica layer are thermal oxidation steps.

3. Method in accordance with claim 2, characterized in that the implantation of step b) is a boron implantation.

4. Method in accordance with claim 3, characterized in that the implantation of step d) is a phosphorous implantation.

5. Method according to claim 4, characterized in that the implantation of step f) is an arsenic implantation.

6. Method in accordance with any of claims 1 to 5, characterized in that it further comprises steps consisting in forming a platinum/silicon alloy at the various openings of the silica layer.

7. Method of producing a field effect transistor having a self-aligned Schottky gate from a substrate of a first conductivity type, characterized in that it comprises the following steps :

a) Introducing the substrate into a reactor for forming a thermal silica layer of a first thickness and then a nitride layer, these layers being defined by a first mask in a predetermined manner ;

b) the chip is placed into an implantation device for implanting a dopant of a first conductivity type, said implantation being masked by said layers ;

c) the substrate is placed into a reactor to form a second thermal silica layer of a second thickness exceeding the first thickness ;

d) the slice is again subjected to an implantation with a dopant of the second conductivity type, said implantation being masked by the second silica layer ;

e) a resin layer is deposited at the locations where the channel is to be formed ;

f) the slice is again subjected to an implantation with a dopant of the second conductivity type, said implantation being masked by the second silica layer and by the resin layer ;

g) the slice is introduced into a chamber for selectively attacking the nitride in a manner to additionally laterally attack the nitride beneath the resin ;

h) the slice is introduced into a bath for attacking the resin ;

i) the slice is introduced into an oxidating atmosphere within an oven to form a thermal silica layer ;

j) another resin layer is deposited, masking, and openings are formed at the locations where the drain and source contacts are to be arranged, subsequently the slice is introduced into a bath for selective attack of the silica ;

k) the slice is introduced into a bath for attacking the resin, then into a chamber for selective attack of the nitride, then into a bath for selectively attacking the silica for a sufficient duration to attack a thickness substantially corresponding to the first thickness ;

l) metallizations are formed in conventional manner.

**Ansprüche**

1. Verfahren zur Herstellung eines Feldeffekttransistors mit selbstausrichtendem Schottkygate, mit einer Sourcezone und einer Drainzone, die durch eine Kanalzone desselben Leitungstyps, jedoch niedrigerer Dotierung getrennt sind, dadurch gekennzeichnet, daß es die folgenden Schritte umfaßt :

a) auf einem Teil der Oberfläche einer Siliziumscheibe, die mit einem ersten Leitungstyp dotiert ist, wird ein Stapel aus einer Siliziumdioxidschicht einer ersten Dicke und einer Siliziumnitridschicht gebildet, wobei dieser Stapel im wesentlichen einen Bereich überdeckt, wo die Drain-Kanal-Source-Einheiten gebildet werden sollen ;

b) eine oberflächliche Implantation eines Dotiermittels des ersten Leitungstyps wird vorgenommen, wobei diese Implantation durch den genannten Stapel maskiert ist ;

c) eine Siliziumdioxidschicht wird außerhalb der von dem Stapel bedeckten Zonen gebildet, wobei diese Schicht eine zweite Dicke aufweist, die größer ist als die erste ;

d) eine oberflächliche Implantation mit einem Dotiermittel des zweiten Leitungstyps wird vorgenommen, wobei diese Implantation durch die Siliziumdioxidschicht mit der zweiten Dicke maskiert wird ;

e) auf der Nitridschicht wird eine Harzschicht gebildet, welche im wesentlichen diejenige Zone bedeckt, in der der Kanal gebildet werden soll ;

f) eine oberflächliche Implantation wird mit einem Dotiermittel des zweiten Leitungstyps vorgenommen, wobei diese Implantation durch die Harzschicht und durch die Siliziumdioxidschicht mit der zweiten Dicke maskiert wird ;

g) die Nitridschicht wird geätzt, um sie außerhalb der von dem Harz bedeckten Stellen und teilweise unter dieser Harzschicht zu entfernen ;

h) die Harzschicht wird entfernt ;

i) eine Siliziumdioxidschicht wird erneut außerhalb der mit dem Nitrid bedeckten Stellen mit einer Dicke gebildet, die größer als die erste Dicke ist ;

j) eine Harzschicht wird aufgebracht und an den Stellen geöffnet, wo die Drain- und Source-Kontakte angebracht werden sollen, wobei die unter den Öffnungen liegende Siliziumdioxidschicht geätzt wird ;

k) das Harz wird entfernt, das verbleibende Nitrid wird durch selektive Ätzung entfernt, und anschließend wird das Siliziumdioxid bis zu einer der ersten Dicke entsprechenden Dicke geätzt, woraus sich ergibt, daß die Siliziumscheibe an denjenigen Stellen bloßgelegt ist, wo die Source-, Drain- und Kanal-Kontakte angebracht werden sollen ;

l) Metallisierungen werden in herkömmlicher Weise gebildet.

2. Herstellungsverfahren nach Anspruch 1, dadurch gekennzeichnet, daß die verschiedenen Schritte zur Bildung einer Siliziumdioxidschicht Schritte einer thermischen Oxidation sind.

3. Verfahren nach Anspruch 2, dadurch gekennzeichnet, daß die im Schritt b) vorgenommene Implantation eine Implantation von Bor ist.

4. Verfahren nach Anspruch 3, dadurch gekennzeichnet, daß die im Schritt d) vorgenommene Implantation eine Implantation von Phosphor ist.

5. Verfahren nach Anspruch 4, dadurch gekennzeichnet, daß die im Schritt f) vorgenommene Implantation eine Implantation von Arsen ist.

6. Verfahren nach einem der Ansprüche 1 bis 5, dadurch gekennzeichnet, daß es ferner Schritte enthält, die darin bestehen, eine Platin/Silizium-Legierung an den verschiedenen Öffnungen in der Siliziumdioxidschicht zu bilden.

7. Verfahren zur Herstellung eines Feldeffekttransistors mit selbstausrichtendem Schottkygate aus einem Substrat eines ersten Leitungstyps, dadurch gekennzeichnet, daß es die folgenden Schritte umfaßt :

a) das Substrat wird in einen Reaktor eingebracht, um eine thermische Siliziumdioxidschicht einer ersten Dicke und anschließend eine Nitridschicht zu bilden, wobei diese Schichten gemäß einer ersten Maske in vorbestimmter Weise begrenzt werden ;

b) das Plättchen wird in eine Vorrichtung zum Implantieren eingebracht, und ein Dotiermittel eines ersten Leitungstyps wird implantiert, wobei diese Implantation durch die genannten Schichten maskiert wird ;

c) das Substrat wird in einen Reaktor eingebracht, um eine zweite Schicht aus thermischem Siliziumdioxid mit einer zweiten Dicke zu bilden, die größer als die erste ist ;

d) die Scheibe wird erneut einer Implantation eines Dotiermittels des zweiten Leitungstyps unterzogen, wobei diese Implantation durch die zweite Siliziumdioxidschicht maskiert wird ;

e) eine Harzschicht wird auf den Stellen aufgebracht, wo der Kanal gebildet werden soll ;

f) die Scheibe wird erneut einer Implantation mit einem Dotiermittel des zweiten Leitungstyps unterzogen, wobei diese Implantation durch die Zweite Siliziumdioxidschicht und durch die Harzschicht maskiert wird ;

g) die Scheibe wird in eine Kammer zum selektiven Ätzen des Nitrids eingebracht, derart, daß auch seitliches Anätzen des Nitrids unter dem Harz stattfindet ;

h) die Scheibe wird in ein Bad zum Entfernen des Harzes eingebracht ;

i) die Scheibe wird in einen eine oxidierende Atmosphäre enthaltenden Ofen eingebracht, um eine thermische Siliziumdioxidschicht zu bilden ;

j) eine neue Harzschicht wird aufgebracht, eine Maskierung wird vorgenommen, Öffnungen werden an den Stellen angebracht, wo die Drain- und Source-Kontakte angeordnet werden sollen, und anschließend wird die Scheibe in ein Bad zum selektiven Ätzen des Siliziumdioxids eingebracht ;

k) die Scheibe wird in ein Bad zum Entfernen des Harzes und anschließend in eine Kammer zum selektiven Ätzen des Nitrids und schließlich in ein Bad zum selektiven Ätzen des Siliziumdioxids während einer Dauer eingebracht, die geeignet ist, um eine Dicke fortzuätzen, welche im wesentlichen der ersten Dicke entspricht ;

l) Metallisierungen werden in herkömmlicher Weise gebildet.

FIG. 1

FIG. 2

FIG. 3

FIG. 4

FIG. 5

FIG. 6

FIG. 7